# EUROPEAN PATENT APPLICATION

(11) **EP 4 592 998 A1**
(43) Date of publication of application: **30.07.2025**
(21) Application number: 24223337.7
(22) Date of filing: 27.12.2024
(51) Int. Cl.: G09G 3/20, G09G 3/3233, G09G 3/32

(54) **ELECTRONIC DEVICE**

(30) Priority: 26.01.2024 CN 202410107160
(71) Applicant: InnoLux Corporation, Jhu-Nan, Miao-Li County 350 (TW)
(72) Inventor: TSAI, Yu-Shen, 350 Miao-Li County (TW); LIN, Cheng-Hsiao, 350 Miao-Li County (TW); HUANG, Sheng-Feng, 350 Miao-Li County (TW)
(74) Representative: Straus, Alexander

(57) **Abstract**

An electronic device (10A, 10B) includes a first transistor (Tcm) with a control end (C1), a second transistor (Tsw) with a second control end (C2) for receiving a pulse signal (VP), a plurality of driver units (20a, 20b, 30a, 30b), and an electronic unit (D1). The driver units (20a, 20b, 30a, 30b) are coupled in parallel. Each driver unit (20a, 20b, 30a, 30b) includes an input end (A) coupled to the first control end (C1), an output end (B) coupled to the electronic unit (D1), and a control end (C) for receiving an enable signal (S1, S2). The driver units (20a, 20b, 30a, 30b) provide currents to the electronic unit (D1) according to received enable signals (S1, S2). A current (Id) flowing through the electronic unit (D1) is modulated according to the pulse width (W1, W2, W3, W4) of the pulse signal (VP).

## Description

### Field of the Disclosure

The present disclosure relates to an electronic device, particularly to an electronic device with light-emitting function that uses pulse amplitude modulation (PAM) and/or pulse width modulation (PWM) techniques.

### Background of the Disclosure

A light-emitting diode (LED) display is an electronic device that uses light-emitting diodes as pixels to generate images. LED displays work by controlling the brightness and color of each pixel to generate images. Each pixel may be composed of red, green, and blue LEDs, and these LEDs may be controlled independently to produce different colors. Pulse amplitude modulation (PAM) and pulse width modulation (PWM) are both common modulation technologies in LED displays. How to apply these technologies has always been an important issue in this field.

### Summary of the Disclosure

This in mind, the present invention aims at providing new electronic devices with light-emitting function that uses pulse amplitude modulation (PAM) and/or pulse width modulation (PWM) techniques.

This is achieved by an electronic device and according to independent claims. The dependent claims pertain to corresponding further developments and improvements.

### Brief Description of the Drawings

FIG. 1 is a circuit diagram of an electronic device according to an embodiment of the present disclosure.
FIG. 2 is a timing diagram of the signals and currents of the electronic device shown in FIG. 1.
FIG. 3 is a circuit diagram of an electronic device according to another embodiment of the present disclosure.
FIG. 4 is a timing diagram of the signals and currents of the electronic device shown in FIG. 3.
FIG. 5 is a circuit diagram of a memory unit of an electronic device according to another embodiment of the present disclosure.
FIG. 6 is a circuit diagram of an electronic device according to another embodiment of the present disclosure.
FIG. 7 is a timing diagram of the signals and currents of the electronic device shown in FIG. 6.
FIG. 8 is a circuit diagram of an electronic device according to another embodiment of the present disclosure.

### Detailed Description

The present disclosure can be understood by referring to the following detailed description and the accompanying drawings. It should be noted that in order to make it easy for the reader to understand and the drawings concise, many of the drawings in the present disclosure only show part of the electronic device, and the specific components in the drawings are not drawn to scale. In addition, the number and size of the components in the drawings are only for illustration purposes and do not limit the scope of the present disclosure.

Certain terms will be used throughout the present disclosure, including the specification and the appended claims, to refer to specific components. It should be understood by those skilled in the art that different manufacturers of electronic devices may refer to the same component by different names. It is not intended herein to distinguish between components that have the same function but different names.

In the following specification and claims, the words "comprising", "containing", "having" and the like are open-ended words, and therefore should be construed as meaning "containing but not limited to...". Therefore, when the terms "comprising", "containing" and/or "having" are used in the description of the present disclosure, they specify the existence of the corresponding features, regions, steps, operations and/or components, but do not exclude the existence of one or more corresponding features, regions, steps, operations and/or components.

The directional terms used herein, such as "upper", "lower", "front", "rear", "left", "right", etc., are only for reference to the direction of the drawings. Therefore, the directional terms used are for illustrative purposes and do not limit the present disclosure. In the drawings, each drawing illustrates the general features of the methods, structures and/or materials used in a particular embodiment. However, these drawings should not be construed as defining or limiting the scope or nature of the embodiments covered by these embodiments. For example, the relative sizes, thicknesses and positions of the layers, regions and/or structures may be reduced or enlarged for clarity.

When a corresponding component (such as a layer or region) is referred to as "on" another component, it may be directly on another component, or there may be other components between the two. On the other hand, when a component is referred to as "directly on" another component, there is no component between the two. In addition, when a component is referred to as "on" another component, the two have a vertical relationship, and the component may be above or below the other component, depending on the orientation of the device.

It should be understood that when a component or layer is referred to as "connected to" another component or layer, it may be directly connected to the other component or layer, or there may be an intervening component or layer between the two. When a component is referred to as "directly connected to" another component or layer, there is no intervening component or layer between the two. In addition, when a component is referred to as "coupled to another component (or a variation thereof)", it may be directly connected to the other component, or indirectly connected to the other component through one or more intermediate components (e.g., electrical connection).

In the present disclosure, when one component "electrically connects" another component, an electrical signal can flow between the two components for at least one moment during normal operation; when one component is "coupled" to another component, an electrical signal can flow between the two components at a specified time. In the present disclosure, when one component is "disconnected" from another component, an electrical signal cannot flow between the two components at a specified time.

The terms "approximate" or "same" are generally construed to mean within a range of plus or minus 20% of a given value, or within a range of plus or minus 10%, plus or minus 5%, plus or minus 3%, plus or minus 2%, plus or minus 1%, or plus or minus 0.5% of a given value.

The ordinal terms used in the specification and claims, such as "first," "second," etc., are used to modify components and do not imply or represent that the component(s) have any previous ordinal number, nor do they represent the order of one component relative to another, or the order in which they are manufactured. These ordinal numbers are used only to distinguish between components with the same name. The same terminology may not be used in the claims and the specification. Therefore, the first component in the specification may be the second component in the claims.

It should be understood that the embodiments described herein may be modified, recombined, and mixed to complete other embodiments without departing from the spirit of the disclosure. The features of the embodiments may be arbitrarily mixed and matched, as long as they do not violate the spirit of the disclosure or conflict with each other.

In this disclosure, the electronic device may include a display device, a light-emitting device, a backlight device, a virtual reality device, an augmented reality (AR) device, an antenna device, a sensor device, a splicing device, or any combination thereof, but not limited to these. The display device may be a non-self-luminous display or a self-luminous display as needed, and may be a color display or a monochrome display as needed. The antenna device may be a liquid crystal type antenna device or a non-liquid crystal type antenna device, the sensor device may be a sensor device for sensing capacitance, light, heat, or ultrasound, and the splicing device may be a display splicing device or an antenna splicing device, but not limited to these. The electronic unit in the electronic device may include passive components and active components, such as capacitors, resistors, inductors, diodes, transistors, etc. The diode may include a light-emitting diode (LED) or a photodiode. The light-emitting diode may include, for example, an organic light-emitting diode (OLED), a sub-millimeter light-emitting diode (mini LED), a micro light-emitting diode (micro LED), or a quantum dot light-emitting diode (quantum dot LED), but not limited to these. The transistor may include, for example, a top gate thin film transistor, a bottom gate thin film transistor, or a dual gate thin film transistor, but not limited to these. The electronic device may also include fluorescence materials, phosphor materials, quantum dot (QD) materials, or other suitable materials as needed, but not limited to these. The electronic device may have a drive system, a control system, a light source system, etc., and other peripheral systems to support the display device, antenna device, wearable device (for example, including augmented reality or virtual reality devices), vehicle-mounted device (for example, including car windshields), or splicing device.

In some embodiments, the electronic substrate may be a type of electronic device, and the electronic substrate may be at least a combination of a display device and a touch sensor device, so that the electronic substrate has at least a display function and a touch sensing function. The following will take the electronic device as an example to explain the present disclosure, but the design of the present disclosure may be applied to any suitable electronic device.

In addition, the switching element described in the present disclosure may be any electronic element having a switching effect. For example, the switching element may be a thin-film transistor. For example, the thin-film transistor may be a top-gate thin-film transistor, a bottom-gate thin-film transistor, a dual-gate thin-film transistor, or other suitable types of transistors.

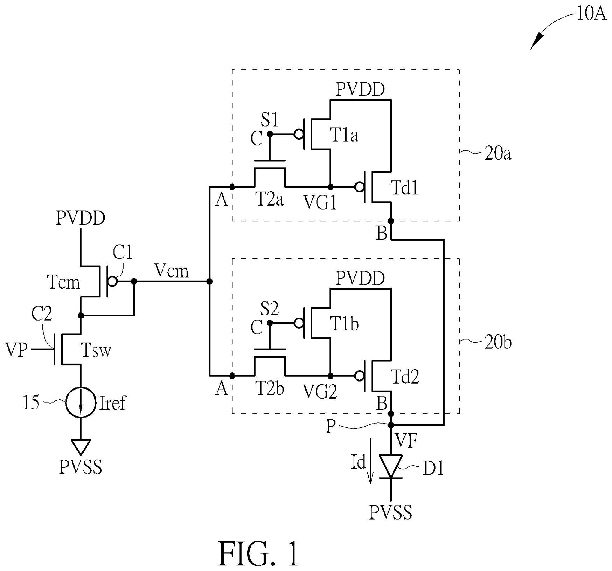

Please refer to FIG. 1, which is a circuit diagram of an electronic device 10A according to an embodiment of the present disclosure. The electronic device 10A comprises a first transistor Tcm, a second transistor Tsw, a plurality of driver units 20a and 20b, and an electronic unit D1. The electronic unit D1 may have a light-emitting function. For example, the electronic unit D1 may comprise a light-emitting diode (LED) or a photodiode. In addition, although the electronic device 10A comprises two driver units 20a and 20b in the embodiment, the electronic device 10A may comprise three or more driver units in other embodiments of the present disclosure. The first transistor Tcm may be a P-type metal-oxide-semiconductor field-effect transistor (hereinafter "PMOS transistor") having a first control end C1. The first control end C1 may be the gate of the first transistor Tcm. Furthermore, a first end of the first transistor Tcm may be the source of the PMOS transistor and is coupled to a first system voltage end PVDD. A second end of the first transistor Tcm may be the drain of the PMOS transistor and is coupled to the first control end C1. The second transistor Tsw may be an N-type metal-oxide-semiconductor field-effect transistor (hereinafter "NMOS transistor") having a second control end C2. The second control end C2 may be the gate of the second transistor Tsw and is used to receive a pulse signal VP. In addition, a first end of the second transistor Tsw may be the drain of the NMOS transistor and is coupled to the first control end C1. A second end of the second transistor Tsw may be the source of the NMOS transistor and is coupled to a second system voltage end PVSS. A voltage provided by the second system voltage end PVSS is lower than a voltage provided by the first system voltage end PVDD. For example, the voltage provided by the first system voltage end PVDD is a positive voltage, and the voltage provided by the second system voltage end PVSS is a ground voltage. But this disclosure is not limited thereto. When the pulse signal VP is high, the second transistor Tsw turns on, making the voltage Vcm of the first control end C1 low, thereby turning on the first transistor Tcm. When the pulse signal VP is low, the second transistor Tsw turns off, making the voltage Vcm of the first control end C1 high, thereby turning off the first transistor Tcm.

The driver units 20a and 20b are coupled in parallel, and each of the driver units 20a and 20b comprises an input end A, an output end B, and a control end C. The input end A is coupled to the first control end C1, the output end B is coupled to the node P, and the control end C receives an enable signal. For example, the control end C of the driver unit 20a receives an enable signal S1, and the control end C of the driver unit 20b receives an enable signal S2. The voltage of the node P is VF. Each driver unit may further comprise a third transistor, a fourth transistor, and a driver transistor. For example, the driver unit 20a may further comprise a third transistor T1a, a fourth transistor T2a, and a driver transistor Td1, and the driver unit 20b may further comprise a third transistor T1b, a fourth transistor T2b, and a driver transistor Td2. The circuit structures of the driver units 20a and 20b are the same. Therefore, the following description will be based on the circuit structure of the driver unit 20a, and the circuit structure of the driver unit 20b can be inferred accordingly. The third transistor T1a may be a PMOS transistor. A first end of the third transistor T1a may be the source of the PMOS transistor and is coupled to the first system voltage end PVDD. A second end of the third transistor T1a may be the drain of the PMOS transistor. A control end of the third transistor T1a may be the gate of the PMOS transistor and is used to receive the enable signal S1. The fourth transistor T2a may be an NMOS transistor. A first end of the fourth transistor T2a is coupled to the input end A. A second end of the fourth transistor T2a is coupled to the second end of the third transistor T1a. A control end of the fourth transistor T2a may be the gate of the NMOS transistor and is used to receive the enable signal S1. The driver transistor Td1 may be a PMOS transistor. A first end of the driver transistor Td1 may be the source of the PMOS transistor and is coupled to the first system voltage end PVDD. A second end of the driver transistor Td1 may be the drain of the PMOS transistor and is coupled to the output end B. A control end of the driver transistor Td1 may be the gate of the PMOS transistor and is coupled to the second end of the third transistor T1a. When both the pulse signal VP and the enable signal S1 are high, the second transistor Tsw turns on, making the voltage Vcm of the first control end C1 low, the third transistor T1a turns off, and the fourth transistor T2a turns on. The voltage Vcm of the first control end C1 would be transmitted to the control end of the driver transistor Td1 through the turned-on fourth transistor T2a, so that the voltage VG1 of the control end of the driver transistor Td1 is equal to the voltage Vcm. This makes the driver transistor Td1 turn on and the driver unit 20a output a current to the electronic unit D1. When the enable signal S1 is low, the third transistor T1a turns on and the fourth transistor T2a turns off. The voltage of the first system voltage end PVDD would be transmitted to the control end of the driver transistor Td1 through the turned-on third transistor T1a, so that the voltage VG1 of the control end of the driver transistor Td1 is equal to the voltage of the first system voltage end PVDD. This makes the driver transistor Td1 turn off and the driver unit 20a stop outputting the current to the electronic unit D1. In addition, VG2 in FIG. 1 is the voltage of the control end of the driver transistor Td2.

In an embodiment of the present disclosure, the electronic device 10A may further comprise a current source 15, coupled between the second end of the second transistor Tsw and the second system voltage end PVSS, to provide a reference current Iref. When the enable signal S1 is high, the current source 15 and the driver unit 20a form a current mirror, and the ratio of the current output from the driver unit 20a to the electronic unit D1 to the reference current Iref is equal to the ratio of the channel width-length ratio of the driver transistor Td1 to the channel width-length ratio of the second transistor Tsw. Similarly, when the enable signal S2 is high, the current source 15 and the driver unit 20b form a current mirror, and the ratio of the current output from the driver unit 20b to the electronic unit D1 to the reference current Iref is equal to the ratio of the channel width-length ratio of the driver transistor Td2 to the channel width-length ratio of the second transistor Tsw. Because the driver transistors Td1 and Td2 may have different channel width-length ratios, if combined with the control of the enable signals S1 and S2, the current Id flowing through the electronic unit D1 can be switched between different current levels.

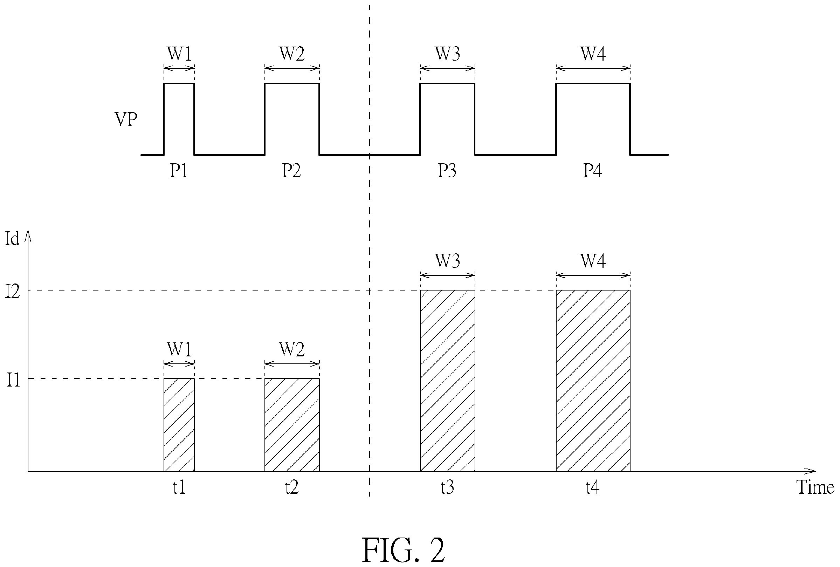

The pulse signal VP has a pulse width, and the current Id passing through the electronic unit D1 is modulated according to the pulse width of the pulse signal VP. Please refer to FIG. 1 and FIG. 2. FIG. 2 is a timing diagram of the signals and current Id of the electronic device 10A shown in FIG. 1. The pulse signal VP has pulses P1, P2, P3, and P4 in time periods t1, t2, t3, and t4, respectively. The pulses P1, P2, P3, and P4 have pulse widths W1, W2, W3, and W4, respectively. In time periods t1 and t2, the driver transistor Td1 of the driver unit 20a is turned on, and the driver transistor Td2 of the driver unit 20b is turned off. In time periods t3 and t4, the driver transistor Td1 of the driver unit 20a is turned off, and the driver transistor Td2 of the driver unit 20b is turned on. In the embodiment, the current Id will be equal to I1 in time periods t1 and t2; and the current Id will be equal to I2 in time periods t3 and t4. Since the channel width-length ratio of the driver transistor Td1 is less than that of the driver transistor Td2, I1 will be less than I2. In addition, the lengths of time periods t1, t2, t3, and t4 are respectively equal to the pulse widths W1, W2, W3, and W4. Therefore, by making the pulse signal VP have different pulse widths, the duration of the current Id flowing through the electronic unit D1 can be adjusted, thereby controlling the light-emitting duration of the electronic unit D1. In addition, by controlling the voltage levels of the enable signals S1 and S2, the conduction states of the driver transistors Td1 and Td2 may be controlled, thereby controlling the magnitude of the current Id passing through the electronic unit D1. When the current Id is larger, the light intensity of the electronic unit D1 will be stronger.

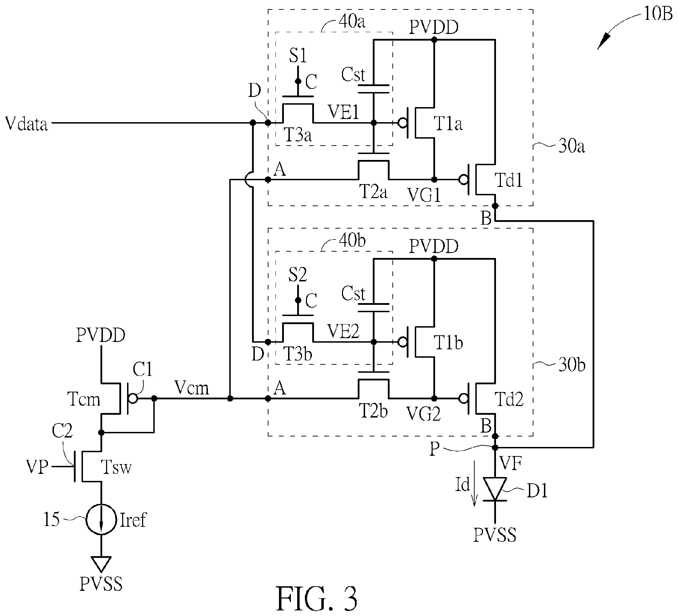

Please refer to FIG. 3, which is a circuit diagram of another embodiment of the electronic device 10B according to another embodiment of the present disclosure. The electronic device 10B comprises a first transistor Tcm, a second transistor Tsw, a plurality of driver units 30a and 30b, and an electronic unit D1. Although the embodiment uses the electronic device 10B including two driver units 30a and 30b as an example, in other embodiments of the disclosure, the electronic device 10B may include three or more driver units. The driver units 30a and 30b are coupled in parallel, and each of the driver units 30a and 30b comprises an input end A, an output end B, a control end C, a data end D, and a memory unit 40a or 40b. The input end A is coupled to the first control end C1, the output end B is coupled to the node P, the data end D is used to receive the data signal Vdata, and the memory units 40a and 40b are used to store the voltage of the data signal Vdata. In addition, the control end C receives an enable signal. For example, the control end C of the driver unit 30a receives the enable signal S1, and the control end C of the driver unit 30b receives the enable signal S2. Furthermore, each driver unit may further comprise a third transistor, a fourth transistor, and a driver transistor. For example, the driver unit 30a may further comprise a third transistor T1a, a fourth transistor T2a, and a driver transistor Td1, and the driver unit 30b may further comprise a third transistor T1b, a fourth transistor T2b, and a driver transistor Td2.

The circuit structures of the driver units 30a and 30b are the same, and the circuit structures of the memory units 40a and 40b are the same. Therefore, the following description will be based on the circuit structures of the driver unit 30a and the memory unit 40a, and the circuit structures of the driver unit 30b and the memory unit 40b can be inferred accordingly. The third transistor T1a may be a PMOS transistor. A first end of the third transistor T1a may be the source of the PMOS transistor and coupled to the first system voltage end PVDD. A second end of the third transistor T1a may be the drain of the PMOS transistor. A control end of the third transistor T1a may be the gate of the PMOS transistor and is used to receive a voltage VE1. The fourth transistor T2a may be an NMOS transistor. A first end of the fourth transistor T2a is coupled to the input end A. A second end of the fourth transistor T2a is coupled to the second end of the third transistor T1a. A control end of the fourth transistor T2a may be the gate of the NMOS transistor and is used to receive the voltage VE1. The driver transistor Td1 may be a PMOS transistor. A first end of the driver transistor Td1 may be the source of the PMOS transistor and coupled to the first system voltage end PVDD. A second end of the driver transistor Td1 may be the drain of the PMOS transistor and coupled to the output end B. A control end of the driver transistor Td1 may be the gate of the PMOS transistor and is coupled to the second end of the third transistor T1a. The memory unit 40a may comprise a storage capacitor Cst and a data transistor T3a. The storage capacitor Cst is coupled between the first system voltage end PVDD and the gate of the third transistor T1a. A first end of the data transistor T3a is coupled to the data end D, a second end of the data transistor T3a is coupled to the storage capacitor Cst, and a control end of the data transistor T3a is used to receive the enable signal S1.

When both the pulse signal VP and the enable signal S1 are at high potential, the second transistor Tsw turns on, making the voltage Vcm of the first control end C1 low, the data transistor T3a turns on, and the data signal Vdata is transmitted through the turned-on data transistor T3a to the gate of the third transistor T1a, which makes the third transistor T1a turn off and the fourth transistor T2a turn on. In this way, the voltage Vcm of the first control end C1 would be transmitted to the control end of the driver transistor Td1 through the turned-on fourth transistor T2a, so that the voltage VG1 of the control end of the driver transistor Td1 is equal to the voltage Vcm. This makes the driver transistor Td1 turn on and the driver unit 30a output a current to the electronic unit D1. When the enable signal S1 is at low potential, the data transistor T3a turns off, and the third transistor T1a and the fourth transistor T2a will remain in their original state since the storage capacitor Cst will store the voltage of the data signal Vdata. In other words, when the enable signal S1 switches from high to low, if the third transistor T1a and the fourth transistor T2a are turned on and turned off respectively, then the third transistor T1a and the fourth transistor T2a will remain turned on and turned off respectively. If the third transistor T1a and the fourth transistor T2a are respectively turned off and turned on, then the third transistor T1a and the fourth transistor T2a will remain turned off and turned on respectively. When the third transistor T1a is turned on and the fourth transistor T2a is turned off, the voltage of the first system voltage end PVDD can be transmitted to the control end of the driver transistor Td1 through the turned-on third transistor T1a, so that the voltage VG1 of the control end of the driver transistor Td1 is equal to the voltage of the first system voltage end PVDD. This makes the driver transistor Td1 turn off and the driver unit 30a stop outputting the current to the electronic unit D1. In the embodiment, the pulse signal VP may also have different pulse widths, to adjust the duration of the current Id passing through the electronic unit D1, thereby controlling the light-emitting duration of the electronic unit D1. In addition, by controlling the voltage levels of the enable signals S1 and S2, the conduction states of the driver transistors Td1 and Td2 may be controlled, thereby controlling the magnitude of the current Id passing through the electronic unit D1.

In an embodiment, the electronic device 10B may further comprise a current source 15, coupled between the second end of the second transistor Tsw and the second system voltage end PVSS, to provide a reference current Iref. When the driver transistor Td1 is turned on, the current source 15 and the driver unit 30a form a current mirror. Similarly, when the driver transistor Td2 is turned on, the current source 15 and the driver unit 30b form a current mirror. Because the driver transistors Td1 and Td2 may have different channel width-length ratios, if combined with the control of the enable signals S1 and S2, the current Id flowing through the electronic unit D1 of the electronic device 10B can be switched between different current levels.

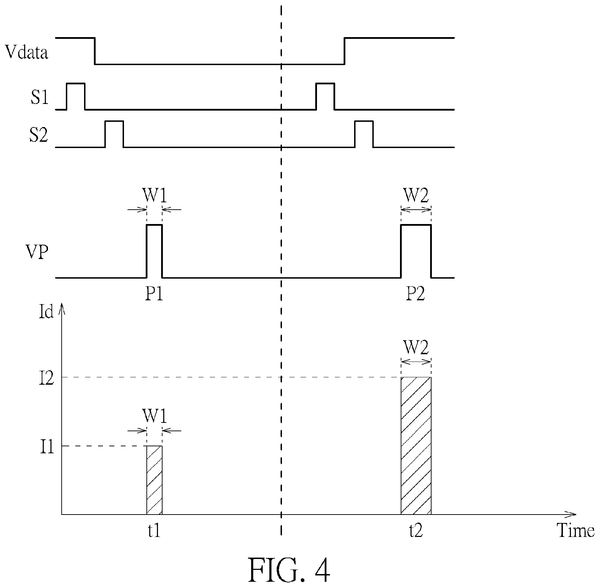

Please refer to FIG. 3 and FIG. 4. FIG. 4 is a timing diagram of the signals and current Id of the electronic device 10B shown in FIG. 3. The pulse signal VP has pulses P1 and P2 in time periods t1 and t2, respectively. The pulses P1 and P2 respectively have pulse widths W1 and W2. In time period t1, the voltages VE1 and VE2 are respectively high and low, thereby turning on the driver transistor Td1 and turning off the driver transistor Td2. In time period t2, the voltages VE1 and VE2 are respectively low and high, thereby turning off the driver transistor Td1 and turning on the driver transistor Td2. In the embodiment, the current Id will be equal to I1 in time period t1; and the current Id will be equal to I2 in time period t2. Since the channel width-length ratio of the driver transistor Td1 is less than that of the driver transistor Td2, I1 is less than I2. In addition, the lengths of time periods t1 and t2 are respectively equal to the pulse widths W1 and W2. Therefore, by making the pulse signal VP have different pulse widths, the duration of the current Id passing through the electronic unit D1 could be adjusted, thereby controlling the light-emitting duration of the electronic unit D1. In addition, by controlling the voltage levels of the enable signals S1 and S2, the conduction states of the driver transistors Td1 and Td2 may be controlled, thereby controlling the magnitude of the current Id passing through the electronic unit D1.

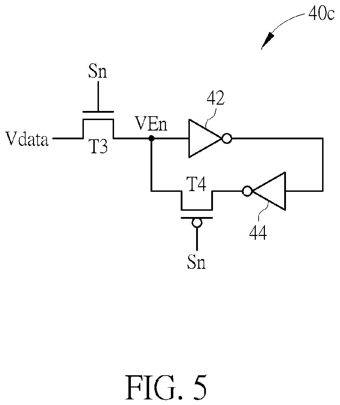

The aforementioned memory unit may comprise a storage capacitor and a data transistor. In other embodiments, the memory unit of the electronic device may comprise two data transistors and two inverters. Please refer to FIG. 5, which is a circuit diagram of a memory unit 40c of another electronic device according to another embodiment of the present disclosure. The memory unit 40c may be used to replace the memory unit 40a and/or the memory unit 40b shown in FIG. 3. The memory unit 40c comprises a first data transistor T3, a second data transistor T4, a first inverter 42, and a second inverter 44. A first end of the first data transistor T3 is coupled to the data end D to receive the data signal Vdata, and a control end of the first data transistor T3 is used to receive an enable signal Sn. The enable signal Sn may be the enable signal S1 or S2 in FIG. 3, and the voltage VEn may be the voltage VE1 or VE2 in FIG. 3. A first end of the second data transistor T4 is coupled to the second end of the first data transistor T3, and a control end of the second data transistor T4 is used to receive the enable signal Sn. An input end of the first inverter 42 is coupled to the second end of the first data transistor T3, an output end of the first inverter 42 is coupled to an input end of the second inverter 44, and an output end of the second inverter 44 is coupled to the second end of the second data transistor T4. The first inverter 42 and the second inverter 44 form a latch circuit, used to store the data signal Vdata.

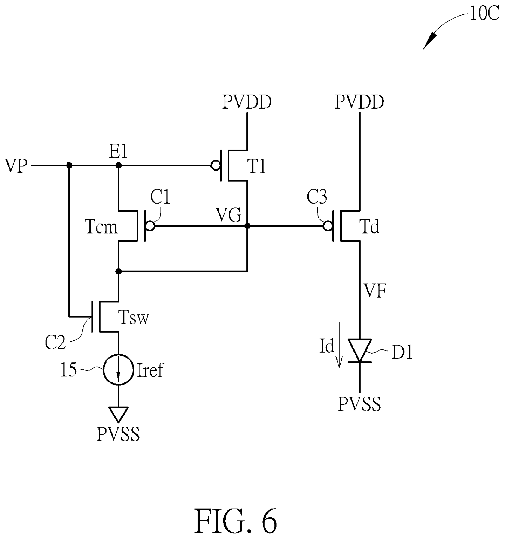

Please refer to FIG. 6, which is a circuit diagram of an electronic device 10C according to another embodiment of the present disclosure. The electronic device 10C comprises a first transistor Tcm, a second transistor Tsw, a third transistor T1, a driver transistor Td, and an electronic unit D1. The first transistor Tcm may be a PMOS transistor, which comprises a first end E1 and a first control end C1. The first end E1 may be the source of the first transistor Tcm, and the first control end C1 may be the gate of the first transistor Tcm. The second transistor Tsw may be an NMOS transistor, which comprises a second control end C2. The second control end C2 may be the gate of the second transistor Tsw, coupled to the first end E1 and used to receive the pulse signal VP. In addition, a first end of the second transistor Tsw may be the drain of the NMOS transistor, and is coupled to the first control end C1. A second end of the second transistor Tsw may be the source of the NMOS transistor, and is coupled to the second system voltage end PVSS. A first end of the third transistor T1 is coupled to the first system voltage end PVDD, a second end of the third transistor T1 is coupled to the first control end C1, and a control end of the third transistor T1 is coupled to the first end E1 of the first transistor Tcm. The driver transistor Td may be a PMOS transistor, which comprises a third control end C3. The third control end C3 may be the gate of the driver transistor Td and is coupled to the first control end C1.

When the pulse signal VP is at a high voltage, the second transistor Tsw is turned on, making the voltage VG of the first control end C1 low, thereby turning on the first transistor Tcm and the driver transistor Td. Therefore, the current Id flows through the electronic unit D1. In addition, when the pulse signal VP is at a low voltage, the second transistor Tsw is turned off and the third transistor T1 is turned on, making the voltage VG of the first control end C1 high, thereby turning off the first transistor Tcm and the driver transistor Td. Therefore, the current Id is equal to zero.

The electronic device 10C may further comprise a current source 15. The third transistor T1 may be a PMOS transistor. The current source 15 is coupled between the second end of the second transistor Tsw and the second system voltage end PVSS, to provide a reference current Iref.

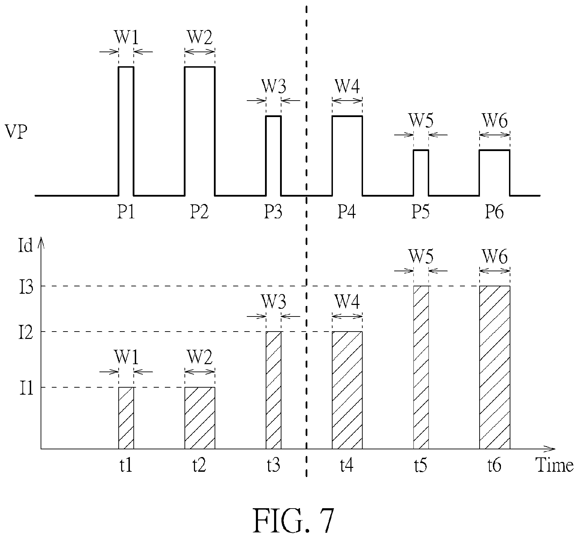

The magnitude and duration of the current Id passing through the electronic unit D1 are modulated according to the pulse amplitude and pulse width of the pulse signal VP, respectively. Please refer to FIG. 6 and FIG. 7. FIG. 7 is a timing diagram of the signals and the current Id of the electronic device 10C shown in FIG. 6. The pulse signal VP has pulses P1, P2, P3, P4, P5, and P6 in time periods t1, t2, t3, t4, t5, and t6, respectively. The pulses P1, P2, P3, P4, P5, and P6 respectively have pulse widths W1, W2, W3, W4, W5, and W6, and the lengths of time periods t1, t2, t3, t4, t5, and t6 are respectively equal to the pulse widths W1, W2, W3, W4, W5, and W6. In addition, when a pulse of the pulse signal VP has a greater amplitude, the corresponding voltage VG will be higher, and the corresponding current Id will be less, as shown in FIG. 7. In FIG. 7, the amplitude of the pulse P1 is equal to the amplitude of the pulse P2, the amplitude of the pulse P3 is equal to the amplitude of the pulse P4, and the amplitude of the pulse P5 is equal to the amplitude of the pulse P6. The amplitude of the pulses P1 and P2 is greater than the amplitude of the pulses P3 and P4, and the amplitude of the pulses P3 and P4 is greater than the amplitude of the pulses P5 and P6. The current Id in time periods t1 and t2 are equal to I1, the current Id in time periods t3 and t4 are equal to I2, and the current Id in time periods t5 and t6 are equal to I3. I1 is less than the I2, and I2 is less than I3.

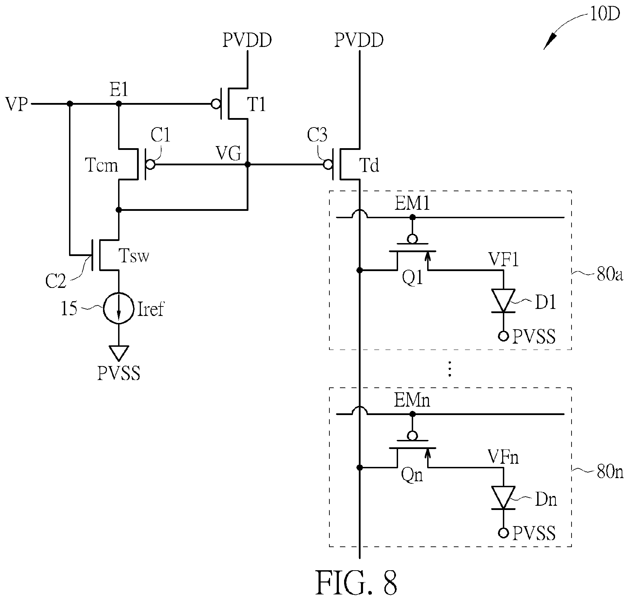

Please refer to FIG. 8, which is a circuit diagram of an electronic device 10D according to another embodiment of the present disclosure. The circuit of the electronic device 10D is similar to the circuit of the electronic device 10C in FIG. 6. The electronic device 10D also comprises the first transistor Tcm, the second transistor Tsw, the third transistor T1, the driver transistor Td, and the current source 15. The difference between the two electronic devices 10C and 10D is that the electronic device 10D further comprises a plurality of light-emitting units 80a to 80n. Each of the light-emitting units 80a to 80n comprises an electronic unit and a switching transistor. For example, the light-emitting unit 80a comprises an electronic unit D1 and a switching transistor Q1, and the light-emitting unit 80n comprises an electronic unit Dn and a switching transistor Qn. Each of the switching transistor Q1 to Qn may be a PMOS transistor, the gates of the switching transistors Q1 to Qn serve as control ends for receiving corresponding switch signals (e.g., switch signals EM1 to EMn). Taking the light-emitting unit 80a as an example, when the switch signal EM1 is at a high voltage, the switching transistor Q1 is turned off, and the electronic unit D1 has no current passing through. When the driver transistor Td is turned on and the switch signal EM1 is at a low voltage, the switching transistor Q1 is turned on, and a current from the first system voltage end PVDD may flow through the driver transistor Td, the switching transistor Q1, and the electronic unit D1. Similarly, when the switch signal EMn is at a high voltage, the switching transistor Qn is turned off, and the electronic unit Dn has no current passing through. When the driver transistor Td is turned on and the switch signal EMn is at a low voltage, the switching transistor Qn is turned on, and a current from the first system voltage end PVDD may flow through the driver transistor Td, the transistor Qn, and the electronic unit Dn. The magnitude of the current passing through the electronic unit D1 is modulated according to the amplitude of the pulse of the pulse signal VP, and the duration of the current passing through the electronic unit D1 is modulated according to the width of the pulse of the pulse signal VP. Similarly, the magnitude of the current passing through the electronic unit Dn is modulated according to the amplitude of the pulse of the pulse signal VP, and the duration of the current passing through the electronic unit Dn is modulated according to the width of the pulse of the pulse signal VP. The magnitude of the current passing through the electronic unit D1 and the magnitude of the current passing through the electronic unit Dn are modulated according to the amplitude of the same pulse of the pulse signal VP or the amplitudes of different pulses of the pulse signal VP. The duration of the current passing through the electronic unit D1 and the duration of the current passing through the electronic unit Dn is modulated according to the width of the same pulse of the pulse signal VP or the widths of different pulses of the pulse signal VP. When the switch signals EM1 and EMn are at a low voltage and the pulse signal VP is at a high voltage, the switching transistors Q1 and Qn are turned on, and the magnitudes and the durations of the currents passing through the electronic units D1 and Dn are modulated according to the amplitude and the width of the same pulse of the pulse signal VP. If the switching transistors Q1 and Qn are not turned on at the same time, the magnitudes of the currents passing through the electronic units D1 and Dn are modulated according to the amplitudes of different pulses of the pulse signal VP, and the durations of the currents passing through the electronic units D1 and Dn are modulated according to the widths of different pulses of the pulse signal VP. In addition, VF1 and VFn in FIG. 8 respectively represent the voltages at the ends of the electronic unit D1 and the electronic unit Dn. When the driver transistor Td and the switching transistor Q1 are turned on, the voltage VF1 is high, so the electronic unit D1 illuminates. When the driver transistor Td and the switching transistor Qn are turned on, the voltage VFn is high, so the electronic unit Dn illuminates.

The embodiments of the present disclosure modulate the pulse signal VP through pulse amplitude modulation (PAM) and/or pulse width modulation (PWM) techniques. Therefore, for LED displays, corresponding pulse signal(s) VP may be modulated by PAM and/or PWM according to the grayscale of each pixel of the display, so that the magnitude and duration of the current flowing through each electronic unit (e.g., D1 and Dn) may better meet the needs of each electronic unit.

## Claims

1. An electronic device (10A, 10B), **characterized by** comprising:
a first transistor (Tcm), comprising a first control end (C1);
a second transistor (Tsw), coupled to the first transistor (Tcm), and comprising a second control end (C2) for receiving a pulse signal (VP) having a pulse width (W1, W2, W3, W4);
a plurality of driver units (20a, 20b, 30a, 30b), coupled in parallel, each driver unit (20a, 20b, 30a, 30b) comprising an input end (A), an output end (B), and a control end (C), the input end (A) being coupled to the first control end (C1), the output end (B) being coupled to a node (P), the control end (C) receiving an enable signal (S1, S2); and
an electronic unit (D1), coupled to the node;
wherein the each driver unit (20a, 20b, 30a, 30b) provides a current to the electronic unit (D1) according to the enable signal (S1, S2), and a current (Id) flowing through the electronic unit (D1) is modulated according to the pulse width (W1, W2, W3, W4) of the pulse signal (VP).

2. The electronic device (10A) of claim 1, **characterized in that** the each driver unit (20a , 20b) further comprises:
a third transistor (T1a , T1b), comprising:
a first end, coupled to a first system voltage end (PVDD);
a second end; and
a control end, for receiving the enable signal (S1, S2);
a fourth transistor (T2a , T2b), comprising:
a first end, coupled to the input end (A);
a second end, coupled to the second end of the third transistor (T1a , T1b); and
a control end, for receiving the enable signal (S1, S2); and
a driver transistor (Td1 , Td2), comprising:
a first end, coupled to the first system voltage end (PVDD);
a second end, coupled to the output end (B); and
a control end, coupled to the second end of the third transistor (T1a , T1b).

3. The electronic device (10B) of claim 1, **characterized in that** the each driver unit (30a, 30b) further comprises a data end (D) and a memory unit (40a, 40b, 40c), the data end (D) is used to receive a data signal (Vdata), and the memory unit (40a, 40b, 40c) is used to store a voltage level of the data signal (Vdata).

4. The electronic device (10B) of claim 3, **characterized in that** the memory unit (40a, 40b) comprises:
a storage capacitor (Cst), having a first end coupled to a first system voltage end (PVDD); and
a data transistor (T3a, T3b), comprising:
a first end, coupled to the data end (D);
a second end, coupled to a second end of the storage capacitor (Cst); and
a control end, for receiving the enable signal (S 1, S2).

5. The electronic device (10B) of claim 4, **characterized in that** the each driver unit (30a, 30b) further comprises:
a third transistor (T1a, T1b), comprising:
a first end, coupled to the first system voltage end (PVDD);
a second end; and
a control end, coupled to the second end of the data transistor (T3a, T3b);
a fourth transistor (T2a, T2b), comprising:
a first end, coupled to the input end (A);
a second end, coupled to the second end of the third transistor (T1a, T1b); and
a control end, coupled to the second end of the data transistor (T3a, T3b); and
a driver transistor (Td1, Td2), comprising:
a first end, coupled to the first system voltage end (PVDD);
a second end, coupled to the output end (B); and
a control end, coupled to the second end of the third transistor (T1a, T1b).

6. The electronic device (10B) of claim 5, **characterized in that** the third transistor (T1a, T1b) and the driver transistor (Td1, Td2) are P-type metal-oxide-semiconductor field-effect transistors, and the data transistor (T3a, T3b) and the fourth transistor (T2a, T2b) are N-type metal-oxide-semiconductor field-effect transistors.

7. The electronic device (10B) of claim 3, **characterized in that** the memory unit (40c) comprises:
a first data transistor (T3), comprising:
a first end, coupled to the data end (D);
a second end; and
a control end, for receiving the enable signal (S 1, S2);
a second data transistor (T4), comprising:
a first end, coupled to the second end of the first data transistor (T3);
a second end; and
a control end, for receiving the enable signal (S 1, S2);
a first inverter (42), having an input end coupled to the second end of the first data transistor (T3); and
a second inverter (44), having an input end coupled to an output end of the first inverter (42), and an output end coupled to the second end of the second data transistor (T4).

8. The electronic device (10B) of claim 7, **characterized in that** the each driver unit (30a, 30b) further comprises:
a third transistor (T1a, T1b), comprising:
a first end, coupled to a first system voltage end (PVDD);
a second end; and
a control end, coupled to the second end of the first data transistor (T3);
a fourth transistor (T2a, T2b), comprising:
a first end, coupled to the input end (A) of the each driver unit (30a, 30b);
a second end, coupled to the second end of the third transistor (T1a, T1b); and
a control end, coupled to the second end of the first data transistor (T3); and
a driver transistor (Td1, Td2), comprising:
a first end, coupled to the first system voltage end (PVDD);
a second end, coupled to the output end of the each driver unit (B); and
a control end, coupled to the second end of the third transistor (T1a, T1b).

9. The electronic device (10A, 10B) of any of claims 1 to 8, **characterized by** further comprising a current source (15) coupled to a second end of the second transistor (Tsw).

10. The electronic device (10A, 10B) of claim 9, **characterized in that** the each driver unit (20a, 20b, 30a, 30b) and the current source (15) form a current mirror.

11. The electronic device (10A, 10B) of claim 10, **characterized in that** the each driver unit (20a, 20b, 30a, 30b) further comprises a driver transistor (Td1 , Td2), a first end of the driver transistor (Td1 , Td2) is coupled to a first system voltage end (PVDD), and a second end of the driver transistor (Td1 , Td2) is coupled to the electronic unit (D1).

12. The electronic device (10A, 10B) of claim 11, **characterized in that** the current source (15) is configured to provide a reference current (Iref), and a ratio of the current output from the each driver unit (20a, 20b, 30a, 30b) to the electronic unit (D1) to the reference current (Iref) is equal to a ratio of a channel width-length ratio of the driver transistor (Td1 , Td2) to a channel width-length ratio of the second transistor (Tsw).

13. An electronic device (10C, 10D), **characterized by** comprising:
a first transistor (Tcm), comprising a first end (E1) and a first control end (C1);
a second transistor (Tsw), comprising a second control end (C2), the second control end (C2) being coupled to the first end (E1) for receiving a pulse signal (VP) having a pulse width (W1, W2, W3, W4, W5, W6) and a pulse amplitude;
a driver transistor (Td), comprising a third control end (C3), the third control end (C3) being coupled to the first control end (C1); and
a first electronic unit (D1), coupled to the driver transistor (Td);
wherein a magnitude (I1, I2, I3) of a current (Id) flowing through the first electronic unit (D1) is modulated according to the pulse amplitude, and a duration of the current (Id) flowing through the first electronic unit (D1) is modulated according to the pulse width (W1, W2, W3, W4).

14. The electronic device (10C, 10D) of claim 13, **characterized by** further comprising:
a third transistor (T1), comprising:
a first end, coupled to a first system voltage end (PVDD);
a second end, coupled to the first control end (C1); and
a control end, coupled to the first end (E1) of the first transistor (Tcm); and
a current source (15), coupled to a second end of the second transistor (Tsw).

15. The electronic device (10C, 10D) of claim 8, **characterized by** further comprising:
a first switching transistor (Q1), coupled between the driver transistor (Td) and the first electronic unit (D1);
a second electronic unit (Dn); and
a second switching transistor (Qn), coupled between the driver transistor (Td) and the second electronic unit (Dn);
wherein a magnitude of a current flowing through the second electronic unit (Dn) is modulated according to the pulse amplitude, and a duration of the current flowing through the second electronic unit (Dn) is modulated according to the pulse width (W1, W2, W3, W4, W5, W6).
